# EUROPÄISCHE PATENTSCHRIFT

(11) **EP 1 543 618 B1**
(45) Veröffentlichungstag und Bekanntmachung des Hinweises auf die Patenterteilung: **14.10.2009**
(21) Anmeldenummer: 03748089.4
(22) Anmeldetag: 25.09.2003
(51) Int. Cl.: H03K 19/018, H03K 19/0185, H03F 3/50, H03K 19/003

(54) **TRANSISTORSCHALTUNG**
TRANSISTOR CIRCUIT
CIRCUIT A TRANSISTORS

(30) Priorität: 27.09.2002 DE 10245453; 12.11.2002 DE 10252594
(43) Veröffentlichungstag der Anmeldung: 22.06.2005
(73) Patentinhaber: Fraunhofer-Gesellschaft zur Förderung der angewandten Forschung e.V., 80686 München (DE)
(72) Erfinder: SUNDERMEYER, Jan, 90409 Nürnberg (DE); SAUERER, Josef, 91074 Herzogenaurach (DE)
(74) Vertreter: Schoppe, Fritz
(86) Internationale Anmeldenummer: PCT/EP2003/010677
(87) Internationale Veröffentlichungsnummer: WO 2004/032324

(56) Entgegenhaltungen:
- US-A- 4 645 958
- US-A- 5 485 110
- US-A- 5 825 249

## Beschreibung

Die vorliegende Erfindung bezieht sich auf Transistorschaltungen und insbesondere Transistorschaltungen, die Emitterfolgertransistoren bzw. Sourcefolgertransistoren und Stromquellentransistoren aufweisen, um Stromverstärkungsschaltungen bzw. Pegelverschiebungsschaltungen zu realisieren.

In integrierten Schaltungen für schnelle Elektronik werden zunehmend Technologien eingesetzt, die Transistoren mit vergleichsweise niedrigen Durchbruchspannungen besitzen.

Bei Stromverstärkungsschaltungen bzw. Pegelverschiebungsschaltungen führt dies dazu, daß bei der Emitterfolger-Basiszelle bzw. Sourcefolger-Basiszelle Maßnahmen ergriffen werden müssen, um diese vor zu großen Spannungen zu schützen. Derartige Maßnahmen führen aber in der Regel dazu, daß die Geschwindigkeit der Schaltung reduziert wird.

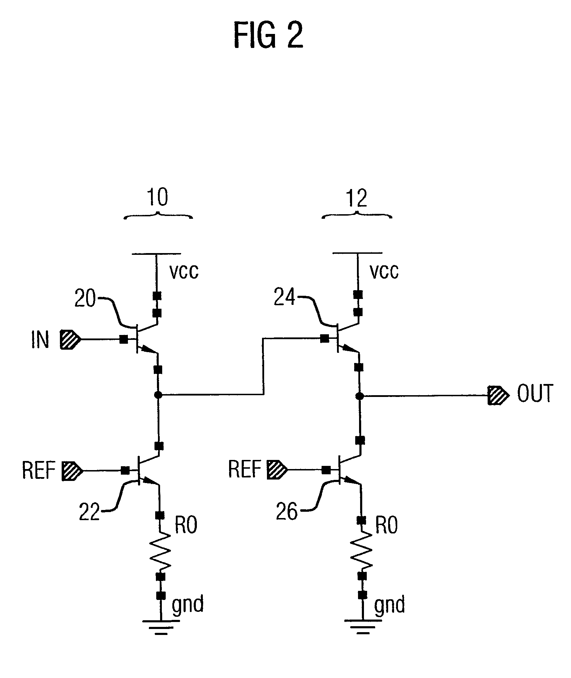

Eine bekannte Stromverstärkungsschaltung bzw. Pegelverschiebungsschaltung ist in Fig. 2 gezeigt.

Die bekannte Schaltung umfaßt eine erste Emitterfolgerstufe 10 und eine zweite Emitterfolgerstufe 12. Die erste Emitterfolgerstufe 10 umfaßt einen ersten Emitterfolgertransistor 20 und einen ersten Stromquellentransistor 22. Die zweite Emitterfolgerstufe 12 umfaßt einen zweiten Emitterfolgertransistor 24 und einen zweiten Stromquellentransistor 26.

Die Kollektoranschlüsse der Emitterfolgertransistoren 20 und 24 sind mit einem Spannungsversorgungspotential VCC verbunden. Am Basisanschluß des ersten Emitterfolgertransistors 20 liegt ein Eingangssignal IN der Transistorschaltung an. Der Emitteranschluß des ersten Emitterfolgertransistors 20 ist mit dem Kollektoranschluß des ersten Stromquellentransistors 22 verbunden. Am Basisanschluß des ersten Stromquellentransistors 22 liegt eine Referenzspannung REF an, und der Emitteranschluß des ersten Stromquellentransistors 22 ist über einen Widerstand R0 mit Masse verbunden.

Der Emitteranschluß des ersten Emitterfolgertransistors 20 ist ferner mit dem Basisanschluß des zweiten Emitterfolgertransistors 24 verbunden. Der Emitteranschluß des zweiten Emitterfolgertransistors 24 ist mit dem Kollektoranschluß des zweiten Stromquellentransistors 26 verbunden. Am Basisanschluß des zweiten Stromquellentransistors 26 liegt ebenfalls die Referenzspannung REF an und der Emitteranschluß des zweiten Stromquellentransistors 26 ist ebenfalls über einen Widerstand R0 mit Masse verbunden. Am Emitteranschluß des zweiten Emitterfolgertransistors 24 wird ferner das Ausgangssignal OUT der Schaltung abgegriffen.

Bei der in Fig. 2 gezeigten Transistorschaltung dienen die Stromquellentransistoren 22 bzw. 26 und die zugeordneten Widerstände R0 dazu, einen Arbeitsstrom durch die Emitterfolgertransistoren 20 und 24 zu definieren. Das Eingangssignal IN ist in der Regel durch ein Signal mit einer Spannung gebildet, die einen Gleichanteil und einen Wechselanteil umfaßt, wobei der Gleichanteil den Emitterfolgertransistor 20 im gesamten Betrieb im durchgeschalteten Zustand hält, so daß dieser die Funktionalität eines Emitterfolgertransistors liefert. Damit liegt am Emitter immer eine Spannung an, die um die Basis-Emitter-Spannung U_{BE} geringer ist als die Basisspannung. Beispielsweise kann es sich bei dem Eingangssignal um ein Signal handeln, das einen Gleichanteil von mehreren Volt aufweist und einen Wechselanteil von mehreren hundert Millivolt, um die das Eingangssignal um den Gleichanteil schwankt.

Die um die Basis-Emitter-Spannung U_{BE} des ersten Emitterfolgertransistors 20 reduzierte Eingangsspannung IN liegt an der Basis des zweiten Emitterfolgertransistors 24 an. Der zweite Emitterfolgertransistor 24 wird ebenfalls so betrieben, daß am Emitter desselben eine Spannung anliegt, die um die Basis-Emitter-Spannung U_{BE} geringer ist als die Basisspannung desselben. Somit liegt der Gleichanteil der Spannung OUT der in Fig. 2 gezeigten Transistorschaltung um 2·U_{BE} unter dem der Eingangsspannung IN.

Mehrere Emitterfolgerstufen werden üblicherweise hintereinander geschaltet, wobei in Fig. 2 zwei solche Stufen gezeigt sind, um eine größere Stromverstärkung oder eine größere Pegelverschiebung zu erreichen. Diese Hintereinanderschaltung hat jedoch zur Folge, daß die Stromquellentransistoren 22 bzw. 26 der verschiedenen Stufen unterschiedlich mit Spannung belastet werden, nachdem die Emitterspannungen derselben identisch sind und die Kollektorspannungen abnehmen (IN-U_{BE} für die erste Stufe 10, IN-2·U_{BE} für die zweite Stufe 12 usw. für optionale weitere Stufen).

Damit die Stromquellentransistoren der jeweiligen Emitterfolgerstufen ordnungsgemäß arbeiten, muß die am Basisanschluß anliegende Referenzspannung REF kleiner sein als die am Kollektor der Stromquellentransistoren anliegenden Spannungen. Um somit eine funktionstüchtige mehrstufige Transistorschaltung zu erhalten, muß bei der bekannten Schaltung, bei der an den Stromquellentransistoren 22 bzw. 26 jeweils identische Referenzspannungen REF anliegen, diese Referenzspannung kleiner sein als der Gleichanteil des kleinsten Ausgangssignals. Ein solches Referenzsignal hat eine hohe Kollektor-Emitter-Spannung am Stromquellentransistor der ersten Emitterfolgerstufe zur Folge, während diese Kollektor-Emitter-Spannung aufgrund abnehmender Kollektorspannung für nachfolgende Stufen abnimmt.

Somit werden bei der üblichen, in Fig. 2 gezeigten Verschaltung die Stromquellentransistoren mehrerer Stufen unterschiedlich belastet, der der ersten sehr stark, der der letzten sehr gering. Wie ausgeführt wurde, muß, wenn alle Stromquellentransistoren arbeiten sollen, der Spannungswert am ersten Stromquellentransistor so hoch gewählt werden, daß bei Technologien mit niedrigen Durchbruchspannungen dieser überlastet wird.

Die obige aus dem Stand der Technik bekannte Schaltung wurde anhand von Bipolartransistoren beschrieben. Es ist jedoch klar, daß eine Schaltung mit identischer Funktionalität auch unter Verwendung von Feldeffekttransistoren realisiert werden kann.

Dokument US4874970 beschreibt eine Ausgangstreiberschaltung welche am Eingang zwei als Differenzverstärker gekoppelte Transistoren besitzt. Der Ausgang des Differenzverstärkers ist mit einen Paar von Ausgangstransistoren verbunden, welche in Darlington bzw. Emitterfolger-Konfiguration beschalten sind und welche ein Ausgangs pull-up Signal am Ausgangsanschluss einer integrierten Schaltung, welche den besagten Ausgangstreiber enthält, bewirken. Der komplementäre Ausgang des Differenzverstärkerpaares ist mit einer Schaltung verbunden welche einen kurzen pull-down Puls an den Ausgang liefert um die Ausgangstransistoren während eines high to low Überganges schnell abzuschalten. Die Verwendung des Ausgangstreibers minimiert den vom Differenzverstärker benötigten Strom und die schnelle pull-down Schaltung eliminiert den Geschwindigkeitsnachteil aufgrund der Verwendung eines Transistorpaares als Ausgangsstufe.

Die Aufgabe der vorliegenden Erfindung besteht darin, eine Transistorschaltung mit mehreren Emitterfolgerstufen bzw. Sourcefolgerstufen zu schaffen, die die Verwendung von Transistoren mit niedrigen Durchbruchspannungen ohne Beeinträchtigung der Geschwindigkeit der Schaltung ermöglichen.

Diese Aufgabe wird durch eine Transistorschaltung gemäß Anspruch 1 und eine Transistorschaltung gemäß Anspruch 5 gelöst.

Gemäß der vorliegenden Erfindung wird das Steuersignal für den Stromquellentransistor einer nachfolgenden Stufe aus der Spannung am Emitter bzw. an der Source des vorhergehenden Stromquellentransistors gewonnen. Da die Stromquellentransistoren bei der erfindungsgemäßen Transistorschaltung jeweils als Stromquellen arbeiten, liegt die Emitterspannung bzw. Sourcespannung derselben jeweils um eine vorbestimmte Differenzspannung (die Basis-Emitter-Spannung U_{BE} oder die Gate-Source-Spannung U_{GS}) unter der an der Basis bzw. dem Gate des jeweiligen Stromquellentransistors anliegenden Referenzspannung. Somit nimmt die Referenzspannung ausgehend von der ersten Stufe für die nachfolgenden Stufen ab. Dadurch kann erreicht werden, daß die Spannungsbelastung für die Stromquellentransistoren der einzelnen Stufen im wesentlichen identisch ist.

Die Referenzspannung für den Stromquellentransistor der ersten Stufe wird so gewählt, daß der erste Transistor optimal angesteuert wird, d. h. ohne Überlastung desselben zusammen mit einem Emitterwiderstand bzw. Sourcewiderstand einen gewünschten Arbeitsstrom durch den Emitterfolgertransistor bzw. Sourcefolgertransistor liefert. Für die Stromquellentransistoren nachfolgender Stromquellen wird die jeweilige Referenzspannung aus einer der vorhergehenden Emitterfolgerstufen bzw. Sourcefolgerstufen erzeugt, indem entweder die Spannung direkt am Emitter/der Source des Stromquellentransistors abgegriffen wird oder an einem durch Widerstände oder Dioden noch weiter abgesenkten Spannungspunkt.

Die vorliegende Erfindung ermöglicht somit eine neuartige Verschaltung der Stromquellentransistoren, die dazu führt, daß die Transistoren innerhalb der zulässigen Grenzen bleiben, ohne daß die Geschwindigkeit der Schaltung beeinträchtigt wird. Dies ist erfindungsgemäß möglich, da die Referenzspannungen für die Stromquellentransistoren variabel sind, so daß die Referenzspannungen für niedrigere Stufen höher eingestellt sein können als für höhere Stufen. Des weiteren ermöglicht die erfindungsgemäße Verschaltung eine Verstärkungsüberhöhung für hohe Frequenzen, die zur Steigerung der Geschwindigkeit der Gesamtschaltung genutzt werden kann. Dieselbe kann jedoch auch mit einfachen Mitteln vermieden werden.

Die vorliegende Erfindung schafft eine Transistorschaltung, die ein sicheres Betreiben einer Emitterfolgerschaltung bzw. Sourcefolgerschaltung mit mehreren Stufen innerhalb spezifizierter Spannungsgrenzen ermöglicht. Ferner tritt erfindungsgemäß kein Geschwindigkeitsverlust durch die Anpassung der Schaltung, um das Überschreiten von Durchbruchspannungen zu verhindern, auf. Ferner besitzt die erfindungsgemäße Transistorschaltung einen weiteren Vorteil hinsichtlich einer erzeugten Verstärkungsüberhöhung bei hohen Frequenzen, die zur Geschwindigkeitssteigerung der Gesamtschaltung genutzt werden kann.

Bevorzugte Ausführungsbeispiele der vorliegenden Erfindung werden nachfolgend Bezug nehmend auf die beiliegenden Zeichnungen näher erläutert. Es zeigen:
- Fig. 1: ein Schaltungsdiagramm eines bevorzugten Ausfüh- rungsbeispiels einer erfindungsgemäßen Transi- storschaltung; und
- Fig. 2: ein Schaltungsdiagramm einer herkömmlichen Tran- sistorschaltung.

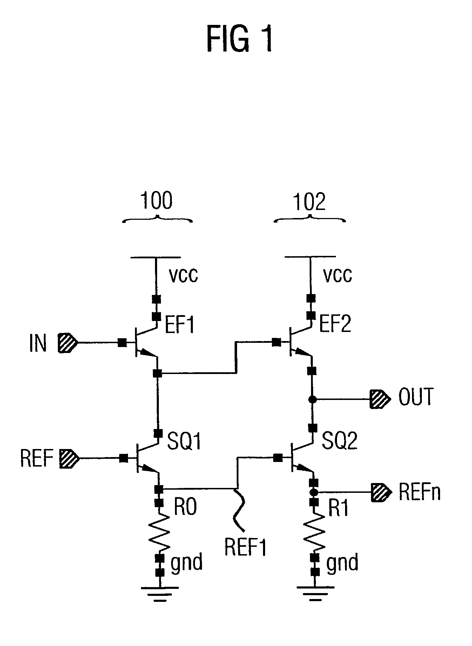

Die in Fig. 1 gezeigte Emitterfolgerschaltung umfaßt eine erste Stufe 100 und eine zweite Stufe 102. Die erste Stufe umfaßt einen ersten Emitterfolgertransistor EF1, einen ersten Stromquellentransistor SQ1 und einen ersten Widerstand R0. Die zweite Stufe 102 umfaßt einen zweiten Emitterfolgertransistor EF2, einen zweiten Stromquellentransistor SQ2 und einen zweiten Widerstand R1.

Die Kollektoren der Emitterfolgertransistoren EF1 und EF2 sind mit einem Versorgungsspannungspotential VCC verbunden. An dem Basisanschluß bzw. der Basis des ersten Emitterfolgertransistors EF1 liegt die Eingangsspannung IN an, so daß diese Basis einen Eingang der gezeigten Schaltung darstellt. Der Emitter des ersten Emitterfolgertransistors EF1 ist mit dem Kollektor des ersten Stromquellentransistors SQ1 und der Basis des zweiten Emitterfolgertransistors EF2 verbunden. An der Basis des ersten Stromquellentransistors SQ1 liegt eine Referenzspannung REF an. Der Emitter des ersten Stromquellentransistors SQ1 ist über den Widerstand R0 mit Masse verbunden. Ferner ist der Emitter des Stromquellentransistors SQ1 mit der Basis des zweiten Stromquellentransistors SQ2 verbunden.

Der Emitter des zweiten Emitterfolgertransistors EF2 ist mit dem Kollektor des zweiten Stromquellentransistors SQ2 verbunden. Ferner ist am Emitter des zweiten Emitterfolgertransistors EF2 eine Ausgangsspannung OUT der Transistorschaltung abgreifbar, so daß dieser einen Ausgang der Transistorschaltung darstellt. Der Emitter des zweiten Stromquellentransistors SQ2 ist über den Widerstand R1 mit Masse verbunden.

Wie die oben Bezug nehmend auf Fig. 2 erläuterte Schaltung kann die in Fig. 1 gezeigte Schaltung vorzugsweise verwendet werden, um ein Eingangssignal zu verarbeiten, dessen Eingangsspannung IN einen Gleichsignalanteil und einen Wechselsignalanteil aufweist, wobei der Wechselsignalanteil Schwankungen um den Gleichsignalanteil von mehreren hundert Millivolt bewirkt. Die Emitterfolgertransistoren EF1 und EF2 arbeiten wiederum als Emitterfolger, so daß die Spannung an den Emittern derselben jeweils um die Basis-Emitter-Spannung U_{BE} geringer ist als die Spannung an den Basisanschlüssen derselben. Auch die Stromquellentransistoren SQ1 und SQ2 arbeiten in diesem Modus, so daß die Spannung am Emitter des Stromquellentransistors SQ1, d. h. REF1, um U_{BE} geringer ist als die an der Basis anliegende Referenzspannung REF, d. h. REF1=REF-U_{BE}. Ferner beträgt eine am Emitter des zweiten Stromquellentransistors SQ2 abgreifbare Referenzspannung REFn für den Stromquellentransistor einer nachgeschalteten optionalen dritten Stufe REFn=REF-2·U_{BE}.

Wie oben Bezug nehmend auf Fig. 2 bereits erläutert wurde, beträgt die Emitterspannung des Emitterfolgertransistors EF1 ferner IN-U_{BE}, während die Emitterspannung des zweiten Emitterfolgertransistors EF2 (die OUT entspricht) IN-2·U_{BE} beträgt. Somit nimmt wiederum die Kollektorspannung ausgehend von dem ersten Stromquellentransistor SQ1 für Stromquellentransistoren höherer Stufen entsprechend ab. Durch die erfindungsgemäße Verschaltung wird jedoch erreicht, daß auch die Referenzspannung ausgehend von der ersten Stufe für die höheren Stufen abnimmt, so daß die Spannungsbelastung für die Stromquellentransistoren der verschiedenen Stufen im wesentlichen identisch bleibt.

Erfindungsgemäß kann die Referenzspannung für die erste Stufe deutlich höher gewählt werden als gemäß dem Stand der Technik, so daß es möglich ist, den ersten Transistor optimal anzusteuern, um einen gewünschten Querstrom für die erste Stufe und somit einen gewünschten Arbeitspunkt für den Emitterfolgertransistor EF1 einzustellen. Dies ist erfindungsgemäß möglich, da die Referenzspannungen für die Stromquellentransistoren nachfolgender Stufen abnehmen. Bei dem in Fig. 1 gezeigten Ausführungsbeispiel wird dies erreicht, indem die Referenzspannung für den Stromquellentransistor SQ2 der zweiten Stufe 102 direkt am Emitter des Stromquellentransistors SQ1 abgegriffen wird.

Bei alternativen Ausführungsbeispielen könnte die Referenzspannung für den zweiten Stromquellentransistor durch die Verwendung eines Spannungsteilers noch weiter abgesenkt werden, indem beispielsweise Widerstände und/oder Dioden zwischen den Emitter des Stromquellentransistors SQ1 und die Basis des Stromquellentransistors SQ2 geschaltet werden.

Die erfindungsgemäße Verschaltung der Stromquellentransistoren führt zu einer Modulation der jeweiligen Referenzspannung und somit auch zu einer Modulation des Querstroms der nachfolgenden Emitterfolgerstufen. Dies führt zu einer Verstärkungsüberhöhung bei hohen Frequenzen, die zur Erweiterung der Gesamtverstärkung verwendet werden kann.

Um diese Erweiterung der Gesamtverstärkung zu vermeiden oder zu verringern, läßt sich zum einen die Referenzleitung mit Kondensatoren glätten, zum anderen kann für den Fall, daß differentielle Signale übertragen werden, die Referenzleitung der jeweiligen Stufe kurzgeschlossen werden. Die genau entgegengesetzte Modulation der beiden Zweige hebt sich dann auf und vermeidet eine Modulation der Referenzspannung wirkungsvoll.

Der Querstrom durch den Emitterfolgertransistor EF1 hängt von dem Referenzsignal des Stromquellentransistors SQ1 und dem Widerstand R0 ab. Der Querstrom durch den zweiten Emitterfolgertransistor EF2 hängt von dem Referenzsignal des Stromquellentransistors SQ2 und dem Widerstand R1 ab. Soll ein gleicher Querstrom bzw. Arbeitsstrom für die Emitterfolgertransistoren EF1 und EF2 eingestellt werden, sind die Widerstände R0 und R1 zu dimensionieren, um die Wirkungen der unterschiedlichen Referenzsignale REF und REF1 auf den jeweiligen Arbeitsstrom auszugleichen.

Obwohl oben Bezug nehmend auf Fig. 1 lediglich zwei Emitterfolgerstufen beschrieben wurden, ist es klar, daß die erfindungsgemäße Transistorschaltung eine größere Anzahl von Stufen aufweisen kann, wobei jeweilige nachfolgende und vorhergehende Stufen entsprechend der oben hinsichtlich der ersten und zweiten Stufe 100 und 102 beschriebenen Verschaltung verschaltet sind.

Bezug nehmend auf Fig. 1 wurde ein bevorzugtes Ausführungsbeispiel der vorliegenden Erfindung anhand von Bipolartransistoren beschrieben. Alternativ kann die vorliegende Erfindung unter Verwendung von Feldeffekttransistoren implementiert werden, die entsprechend verschaltet sind. Hinsichtlich der obigen Beschreibung sind dann jeweils die Basisanschlüsse durch Gateanschlüsse, die Kollektoranschlüsse durch Drainanschlüsse und die Emitteranschlüsse durch Sourceanschlüsse zu ersetzen. Ferner ist die bei Bipolartransistoren auftretende Basis-Emitter-Spannung U_{BE} durch die bei Feldeffekttransistoren auftretende Gate-Source-Spannung U_{GS} zu ersetzen.

Die vorliegende Erfindung eignet sich insbesondere zum Einsatz in digitalen Logiken, beispielsweise ECL-Schaltungen (ECL = Emitter Coupled Logic) oder CML-Logiken (CML = Current Mode Logic). In derartigen Logiken beträgt die Versorgungsspannung VCC üblicherweise zwischen 3 und 5 Volt. Das Eingangssignal besitzt typischerweise einen Gleichanteil in der Größenordnung von VCC und einen Wechselspannungsanteil von ±300 mV.

## Patentansprüche

1. Transistorschaltung mit folgenden Merkmalen:
einem ersten Emitterfolgertransistor (EF1), dessen Emitter mit dem Kollektor eines ersten Stromquellentransistors (SQ1) verbunden ist, wobei die Basis des ersten Emitterfolgertransistors (EF1) einen Eingang (IN) der Schaltung darstellt und die Basis des ersten Stromquellentransistors (SQ1) einen Referenzspannungseingang (REF) darstellt, der ausgelegt ist um eine Referenzspannung zu empfangen; und
einem zweiten Emitterfolgertransistor (EF2), dessen Emitter mit dem Kollektor eines zweiten Stromquellentransistors (SQ2) verbunden ist, wobei der Emitter des ersten Stromquellentransistors (SQ1) und die Basis des zweiten Stromquellentransistors (SQ2) derart verschaltet sind, dass die Spannung (REF1) an der Basis des zweiten Stromquellentransistors (SQ2) von der Spannung am Emitter des ersten Stromquellentransistors (SQ1) abhängt, und wobei der Emitter des zweiten Stromquellentransistors (SQ2) mit einem Widerstand (R1) verbunden ist, der ausgelegt ist, um zusammen mit der Spannung (REF1) an der Basis des zweiten Stromquellentransistors (SQ2) einen Arbeitsstrom durch den zweiten Emitterfolgertransistor (EF2) einzustellen.

2. Transistorschaltung gemäß Anspruch 1, bei der der Emitter des ersten Emitterfolgertransistors (EF1) und die Basis des zweiten Emitterfolgertransistors (EF2) derart verschaltet sind, daß die Spannung an der Basis des zweiten Emitterfolgertransistors (EF2) von der Spannung am Emitter des ersten Emitterfolgertransistors abhängt.

3. Transistorschaltung gemäß Anspruch 1 oder 2, bei der der Emitter des ersten Stromquellentransistors(SQ1) mit der Basis des zweiten Stromquellentransistors (SQ2) verbunden ist.

4. Transistorschaltung gemäß einem der Ansprüche 1 bis 3, die ferner einen weiteren Stromquellentransistor aufweist, wobei der weitere Stromquellentransistor und der zweite Stromquellentransistor (SQ2) derart verschaltet sind, dass die Spannung an der Basis des weiteren Stromquellentransistors von der Spannung am Emitter des zweiten Stromquellentransistors (SQ2) abhängt.

5. Transistorschaltung mit folgenden Merkmalen:
einem ersten Sourcefolgertransistor, dessen Source mit dem Drain eines ersten Stromquellentransistors verbunden ist, wobei das Gate des ersten Sourcefolgertransistors einen Eingang der Schaltung darstellt und das Gate des ersten Stromquellentransistors einen Referenzspannungseingang darstellt, der ausgelegt ist um eine Referenzspannung zu empfangen; und
einem zweiten Sourcefolgertransistor, dessen Source mit dem Drain eines zweiten Stromquellentransistors verbunden ist, wobei die Source des ersten Stromquellentransistors und das Gate des zweiten Stromquellentransistors derart verschaltet sind, dass die Spannung an dem Gate des zweiten Stromquellentransistors von der Spannung an der Source des ersten Stromquellentransistors abhängt, und wobei die Source des zweiten Stromquellentransistors mit einem Widerstand verbunden ist, der ausgelegt ist, um zusammen mit der Spannung an dem Gate des zweiten Stromquellentransistors einen Arbeitsstrom durch den zweiten Sourcefolgertransistor einzustellen.

6. Transistorschaltung gemäß Anspruch 5, bei der die Source des ersten Sourcefolgertransistors und das Gate des zweiten Sourcefolgertransistors derart verschaltet sind, dass die Spannung am dem Gate des zweiten Sourcefolgertransistors von der Spannung an der Source des ersten Sourcefolgertransistors abhängt.

7. Transistorschaltung gemäß Anspruch 5 oder 6, bei der die Source des ersten Stromquellentransistors mit dem Gate des zweiten Stromquellentransistors verbunden ist.

8. Transistorschaltung gemäß einem der Ansprüche 5 bis 7, die ferner einen weiteren Stromquellentransistor aufweist, wobei der weitere Stromquellentransistor und der zweite Stromquellentransistor derart verschaltet sind, daß die Spannung an dem Gate des weiteren Stromquellentransistors von der Spannung an der Source des zweiten Stromquellentransistors (SQ2) abhängt.

## Claims

1. Transistor circuit comprising:
a first emitter follower transistor (EF1) whose emitter is connected to the collector of a first current source transistor (CS1), the basis of the first emitter follower transistor (EF1) representing an input (IN) of the circuit, and the basis of the first current source transistor (CS1) representing a reference voltage input (REF) configured to receive a reference voltage; and
a second emitter follower transistor (EF2) whose emitter is connected to the collector of a second current source transistor (CS2), the emitter of the first current source transistor (CS1) and the basis of the second current source transistor (CS2) being wired such that the voltage (REF1) at the basis of the second current source transistor (CS2) depends on the voltage at the emitter of the first current source transistor (CS1), and the emitter of the second current source transistor (CS2) being connected to a resistor (R1) configured to adjust, along with the voltage (REF1) at the basis of the second current source transistor (CS2), a working current through the second emitter follower transistor (EF2).

2. Transistor circuit as claimed in claim 1, wherein the emitter of the first emitter follower transistor (EF1) and the basis of the second emitter follower transistor (EF2) are wired such that the voltage at the basis of the second emitter follower transistor (EF2) depends on the voltage at the emitter of the first emitter follower transistor.

3. Transistor circuit as claimed in claim 1 or 2, wherein the emitter of the first current source transistor (CS1) is connected to the basis of the second current source transistor (CS2).

4. Transistor circuit as claimed in any of claims 1 to 3, further comprising a further current source transistor, the further current source transistor and the second current source transistor (CS2) being wired such that the voltage at the basis of the further current source transistor depends on the voltage at the emitter of the second current source transistor (CS2).

5. Transistor circuit comprising:
a first source follower transistor whose source is connected to the drain of a first current source transistor, the gate of the first source follower transistor representing an input of the circuit, and the gate of the first current source transistor representing a reference voltage input configured to receive a reference voltage; and
a second source follower transistor whose source is connected to the drain of a second current source transistor, the source of the first current source transistor and the gate of the second current source transistor being wired such that the voltage at the gate of the second current source transistor depends on the voltage at the source of the first current source transistor, and the source of the second current source transistor being connected to a resistor configured to adjust, along with the voltage at the gate of the second current source transistor, a working current through the second source follower transistor.

6. Transistor circuit as claimed in claim 5, wherein the source of the first source follower transistor and the gate of the second source follower transistor are wired such that the voltage at the gate of the second source follower transistor depends on the voltage at the source of the first source follower transistor.

7. Transistor circuit as claimed in claim 5 or 6, wherein the source of the first current source transistor is connected to the gate of the second current source transistor.

8. Transistor circuit as claimed in any of claims 5 to 7, further comprising a further current source transistor, the further current source transistor and the second current source transistor being wired such that the voltage at the gate of the further current source transistor depends on the voltage at the source of the second current source transistor (CS2).

## Revendications

1. Circuit à transistors, aux caractéristiques suivantes:
un premier transistor suiveur d'émetteur (EF1) dont l'émetteur est relié au collecteur d'un premier transistor de source de courant (SQ1), la base du premier transistor suiveur d'émetteur (EF1) représentant une entrée (IN) du circuit et la base du premier transistor de source de courant (SQ1) représentant une entrée de tension de référence (REF) qui est conçue pour recevoir une tension de référence; et
un deuxième transistor suiveur d'émetteur (EF2) dont l'émetteur est relié au collecteur d'un deuxième transistor de source de courant (SQ2), l'émetteur du premier transistor de source de courant (SQ1) et la base du deuxième transistor de source de courant (SQ2) étant connectés de sorte que la tension (REF1) à la base du deuxième transistor de source de courant (SQ2) dépende de la tension à l'émetteur du premier transistor de source de courant (SQ1), et l'émetteur du deuxième transistor de source de courant (SQ2) étant reliée à une résistance (R1) qui est conçue pour régler, ensemble avec la tension (REF1) à la base du deuxième transistor de source de courant (SQ2), un courant de travail dans le deuxième transistor suiveur d'émetteur (EF2).

2. Circuit à transistors selon la revendication 1, dans lequel l'émetteur du premier transistor suiveur d'émetteur (EF1) et la base du deuxième transistor de source de courant (SQ2) sont connectés de sorte que la tension à la base du deuxième transistor suiveur d'émetteur (EF2) dépende de la tension à l'émetteur du premier transistor suiveur d'émetteur.

3. Circuit à transistors selon la revendication 1 ou 2, dans lequel l'émetteur du premier transistor de source de courant (SQ1) est relié à la base du deuxième transistor de source de courant (SQ2).

4. Circuit à transistors selon l'une des revendications 1 à 3, présentant par ailleurs un autre transistor de source de courant, l'autre transistor de source de courant et le deuxième transistor de source de courant (SQ2) étant connectés de sorte que la tension à la base de l'autre transistor de source de courant dépende de la tension à l'émetteur du deuxième transistor de source de courant (SQ2).

5. Circuit à transistors, aux caractéristiques suivantes:
un premier transistor suiveur de source dont la source est reliée au drain d'un premier transistor de source de courant, la porte du premier transistor suiveur de source représentant une entrée du circuit et la porte du premier transistor de source de courant représentant une entrée de tension de référence qui est conçue pour recevoir une tension de référence; et
un deuxième transistor suiveur de source dont la source est reliée au drain d'un deuxième transistor de source de courant, la source du premier transistor de source de courant et la porte du deuxième transistor de source de courant étant connectées de sorte que la tension à la porte du deuxième transistor de source de courant dépende de la tension à la source du premier transistor de source de courant, et la source du deuxième transistor de source de courant étant reliée à une résistance qui est conçue pour régler, ensemble avec la tension à la porte du deuxième transistor de source de courant, un courant de travail dans le deuxième transistor suiveur de source.

6. Circuit à transistors selon la revendication 5, dans lequel la source du premier transistor suiveur de source et la porte du deuxième transistor suiveur de source sont connectées de sorte que la tension à la porte du deuxième transistor suiveur de source dépende de la tension à la source du premier transistor suiveur de source.

7. Circuit à transistors selon la revendication 5 ou 6, dans lequel la source du premier transistor de source de courant est reliée à la porte du deuxième transistor de source de courant.

8. Circuit à transistors selon l'une des revendication 5 à 7, présentant par ailleurs un autre transistor de source de courant, l'autre transistor de source de courant et le deuxième transistor de source de courant étant connectés de sorte que la tension à la porte de l'autre transistor de source de courant dépende de la tension à la source du deuxième transistor de source de courant (SQ2).
